Europäisches Patentamt

European Patent Office

Office européen des brevets

(19)

(11) Publication number : **0 674 388 A1**

(12) **EUROPEAN PATENT APPLICATION**

(21) Application number : **95301252.3**

(22) Date of filing : **27.02.95**

(51) Int. Cl.⁶ : **H03K 3/037**

(30) Priority : **24.03.94 GB 9405804**

(43) Date of publication of application :
**27.09.95 Bulletin 95/39**

(84) Designated Contracting States :
**AT BE CH DE FR GB IE IT LI NL**

(71) Applicant : **DISCOVISION ASSOCIATES**
**2355 Main Street**
**Suite 200**
**Irvine, CA 92714 (US)**

(72) Inventor : **Jones, Anthony Mark**
**31 Templar Road**
**Yate, Bristol BS17 5TF (GB)**
Inventor : **Davison, Michael Paul**
**5 The Butts,**
**Old London Road,**
**Wotton Under Edge**
**Gloucestershire GL12 7DP (GB)**

(74) Representative : **Hale, Peter et al**
**Kilburn & Strode**
**30 John Street**
**London WC1N 2DD (GB)**

(54) Scannable latch and method of using the same.

(57) A novel design for a fully static, see-through-latch with buffering is disclosed, which is capable of being configured to act as either a see-through-latch, a flip-flop as an aid to a test scan which will allow data to be scanned in and out of the latches, and an alternative flip-flop as an aid to testing intervening combinatorial logic.

FIG. 1

EP 0 674 388 A1

## Background of the Invention

The present invention relates to the testing of integrated circuits. An integrated circuit (IC) may be tested to determine whether it is operating as designed and to determine whether the materials from which the IC is made contain defects that affect the operation of the IC. One way to test an IC is through probe-tests, where a direct connection is made to the external pins on the IC and a determination is made as to whether the incoming signals are being correctly processed within the IC. However, such probe-tests have been found to be unsatisfactory. Typically, more than 50% of the devices passing a probe-test will still contain undetected defects, some of which will cause a fatal error when the IC is used.

To improve the quality of the tests, IC designers may add additional circuitry to an IC which allows access to smaller, independently testable elements of the IC. For example, a dedicated test interface inserted at carefully selected points within an IC can give not only the opportunity to view internal signals, but also the opportunity to control the internal signals. By isolating blocks of circuits in such a manner, design faults can be quickly located and more appropriate stimuli applied than if the output of preceding processing stages have to be used. Low maintenance and accurate "modular" test procedures can be created. Additionally, test procedures for an individual block can be developed in tandem with the design of the rest of the IC.

At a particular point in time, the state of the IC is defined by the contents of the registers in the IC. The registers can contain state that is recognized as data, and state that is purely for controlling that data. Such registers are denoted as data path or control-path.

A register holds a data bit within some internal storage element. The control signal which updates the stored data bit is known as the clock input. A register can be implemented as one of two basic types: one type in which the data changes when the clock is asserted, and the other in which the data bit changes when there is a transition on the clock. The two different register types are referred to as a "see-through-latch", or just "latch", and a "flip-flop" respectively. A flip-flop is sometimes referred to as a "master-slave" register.

The flip-flop is the most usual form of register to be used, particularly for the control-path. The latch is smaller and is therefore more desirable in the bulky data path sections of an IC. Those skilled in the art can also make frequent use of latch-based design in the control-path. Using latches in the control path is desirable because of the size advantage, typically 50% of the silicon area. However problems can arise when trying to test logic containing latches.

Testing an IC involves looking at the state of the IC registers, since all state is contained therein. A "snapshot" at a particular moment in time of the data stored in the registers uniquely defines the operation of the IC. The snapshot is sometimes referred to as the "signature" of that moment. By comparing signatures obtained in test with an expected result, design faults and/or manufacturing defects can be detected.

A test procedure such as scanning the registers with the IC operation halted, usually in a bit-serial manner, determines the signature. Generally the scanning mechanism easily allows data to be input as well as output, so specific, demanding signatures may also be applied to search for defects in targeted areas of the IC.

A scan procedure consists of connecting the registers in a chain, and applying extra control signals to move the signature down the chain towards the end of the chain, generally an easily accessed pin of the IC. The start of the chain is often also a pin, so signatures can be input at the same time.

An IC can be designed to contain many such scan chains, interconnected in many different ways. All scan chains have a common feature that the start and end points of the chain are directly accessible by some mechanism, for example external pins, or even another scan chain.

A scan chain of registers is only possible if all the registers in the chain are flip-flops. This precludes using state contained in latches, often most of the data paths, as part of the signature. This problem can be overcome by adding another latch to each register latch, thereby creating a master-slave arrangement. The extra latch is only used for the scan process, and therefore the doubling of the silicon area used is very costly, particularly when the original latch register was only preferred because of the size advantage over a flip-flop register.

Further complications arise when an IC contains more than one clock for controlling the registers. For instance an IC which receives data from a disk, and writes processed data to a display device may have two independent clocks, the disk-clock and the display-clock. A signature using state from both clock "domains" may be desirable, but makes the scan chain very difficult to use.

## Summary of the Invention

By making use of parasitic capacitance in a buffered latch, it possible to store two separate bits of data in a latch previously capable of only storing one data bit. By properly controlling the latch, it is possible to operate the latch in a manner in which it behaves like a conventional flip-flop, with the advantage being that it is more versatile and takes less circuit components.

Using this inventive latch in scan sequences, it is possible to scan the data located in latch registers and in registers operating on different clocks, without the addition of cumbersome circuitry or complex control methods.

## Description of the Drawings

The present invention is illustrated by way of example and not limitation in the figures of the accompanying, in which like references indicate like elements, and in which:

Figure 1 is a schematic view of a first embodiment of the inventive latch.

Figure 2 shows a representative example of the inventive latch as used in both normal operation and in a scan sequence.

Figure 3 is a schematic view of a second embodiment of the inventive latch.

Figure 4 is a schematic view of a third embodiment of the inventive latch.

## Detailed Description of the Invention

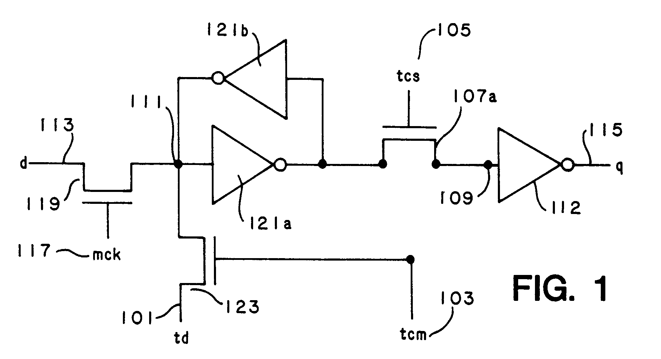

Figure 1 illustrates an inventive latch embodying the present invention. This inventive latch is capable of operating in three different modes, providing three very different storage results. In a first mode, the latch acts as a transparent buffered latch. Data can be fed into the latch via data path 113 and be made available at node 111 of the latch. It is a buffered latch because it includes an inverter 112. During this mode of operation, test slave clock (tcs) 105 closes transistor 107a, allowing the data to transparently move from the data entry path 113 to the data exit path 115. In this mode, a single master clock (mck) 117 controls the data flow through the latch.

In a second mode of operation, the latch allows data to be fed into the latch via test data path 101. The latch is divided into two storage elements by the operation of transistor 107a and the test slave clock 105.

During this second mode of operation, the test slave clock provides signals to open and close transistor 107a, allowing the latch to store data in two sections of the latch. Data will be available at node 109 latch, due to parasitic capacitance, or input capacitance of inverter 112, and data will be available at node 111 as is conventional with a latch. By separating the latch into two sections and controlling the test master clock (tcm) 103, additional data can now be fed into the latch via test data path 101 where it can be stored in section 111 of the latch. During this mode, master clock 117 provides a signal to open transistor 119, preventing data from entering the latch via data line 113.

In a third mode of operation, data is fed into the latch via data line 113 under the control of master clock 117 and made available at node 111. By controlling the latch with test slave clock 105, data is available independently in both nodes 111 and 109. In this mode, no data flows into the latch via test data line 101 because test master clock 103 provides a signal to open transistor 123.

From the preceding description one can see that during a first mode of operation the latch operates as a conventional buffered latch, transparently moving data from data path 113 to data exit path 115 of the latch. In the second and third modes of operation, the latch operates as a Scannable flip-flop, allowing two bits of separate data to be made available at both node 111 and node 109. Advantageously, only a few additional circuit elements are required to make the inventive latch from a conventional buffered latch. Control means, known in the art (and not shown in the figures) can be configured to control the innovative latch via the master clock, the test master clock and the test slave clock.

The inventive latch is capable of making two separate bits of data available at nodes 111 and 109. Those skilled in the art will recognize that the actual electrical charge associated with this data will be stored in two separate portions of the latch. It is not necessary to detail the physics of the electrical charge storage to understand and practice the present invention. For the purposes of this patent, the first storage region in the latch is defined as the region which stores the data available at node 111 and the second storage region is defined to be the region which stores the data available at node 109. The actual storage mechanism will depend on the inverters 121a, 121b and 112 that are used to implement the invention.

Conventional flip-flop devices consist of two clocked latches in series. The first latch is the master latch, through which data enters under the control of a master clock. The second latch is the slave latch, through which data from the first latch is transferred under the control of a slave clock.

Data is therefore moved sequentially into the first latch, under the control of the master clock, and then moved into the slave latch, under the control of the slave clock which is operating on a different phase than the master clock. If the master and slave clocks were not operating on different phases, then the entire flip-flop would become transparent, with data entering the master and emerging at the slave at the same time. Because the two clocks are operating on different phases, the flip-flop is capable of storing two bits of data;

one bit of data in the master and another one in the slave.

The present invention can be utilized as a flip-flop in the third mode of operation. By making use of parasitic capacitance, transistor 107a can be controlled to allow two bits of data to be stored in one latch. Data on data line 113 is allowed into the latch when the master clock 117 receives a logic HIGH signal, closing transistor 119. The data is then stored in the first storage region of the latch, by the conventional means, using two inverters 121a and 121b. This data bit is now available to be read at node 111. If transistor 107a is closed (as it is in the first mode of operation) the data bit would continue through node 109 of the latch and be made available at data exit path 115. However, if the latch is controlled by making test slave clock 105 a logic LOW signal, then this first data bit will not move on to node 109 of the latch. In the next phase, new data is prevented from entering the latch by a logic LOW signal received by transistor 119 from master clock 117. But the data is allowed to move the second storage region and be made available at node 109 by closing transistor 107a, with a logic HIGH signal from test slave clock 105.

In the next phase, a new, second, bit of data will be allowed into node 111 of the latch by master clock 117 (by transmitting a logic HIGH signal to transistor 119 as described above). The latch is now holding two bits of data; the second bit to enter is available at node 111 and the first bit to enter is available at node 109.

The parasitic capacitance used to hold the data available at node 109 has been found to be capable of retaining the bit for approximately 1 millisecond. This period of time is acceptable for many applications, in that the data available at node 109 will be accessed via line 115 by another part of the logic circuitry within 1 millisecond. The duration of the retention of this bit depends on the particular configuration of this dynamic memory element, in particular the size of inverter 112 and the input capacitance associated with it.

The second mode of operation has been found to be useful during testing operations when data is being scanned into the latch. The operation of the latch will be described in the context of a testing routine, however, those skilled in the art will be able to make use of the inventive features in other applications. The inventive latch is particularly suitable for testing purposes, since the dynamic nature of node 109 can be controlled to operate only during a test procedure, thus it does not restrict the general use of the latch during a normal run.

The second mode of operation is similar to the third mode of operation in that two different bits of data can be stored in the single latch. Referring again to figure 1, the second mode of operation is different because data no longer enters the latch via data line 113. Master clock 117 opens transistor 119 with a logic LOW signal during the second mode of operation. The latch is now controlled by test master clock 103 and test data (td) enters the latch via test data line 101.

During a first phase of operation, the test master clock 103 allows data into section 111 of the latch by transmitting a logic HIGH signal to close a transistor 123. The data cannot continue onto node 109 of the latch because the test slave clock opens transistor 107a. In the next phase, the test master clock transmits a logic LOW signal to transistor 123 which stops data from entering the latch over the test data line, and the test slave clock closes transistor 107a allowing the data available at node 111 to move onto node 109 of the latch. In the next phase, the test master clock transmits a logic HIGH signal to the transistor 123 and data again flows into the latch via the test data line and remains in section 111 of the latch. Thus, two different data bits are stored in the single latch.

This mode of operation is useful in a scan operation involving logic sequences that utilize both latches and conventional flip-flops as storage devices. Logic designers find it useful to use both latches and flip-flops in logic sequences. In some situations, these storage devices are controlled by different clocks. During a normal run of the sequential logic, data will be held in these storage devices and, using conventional scan procedures, this original data can be lost when the signature is scanned out for observation. This is an undesirable result in many situations.

For example, integrated circuits can use a control logic to control the operation of the various blocks of circuits in the overall integrated circuit. In the field of video compression an integrated circuit maybe required to decode video signals that have been compressed using different standards. Thus an integrated circuit designed to decode compressed video can have an overall logic control state that will control the operation of the integrated circuits logic blocks, depending on the particular compression standard that was used to compress the incoming video data.

During a verification test procedure it is useful to scan the contents of the various storage registers to determine what the signature is at a particular point in time. By comparing the actual signature at a particular time, with the signature that is expected, a designer can determine if problems exist.

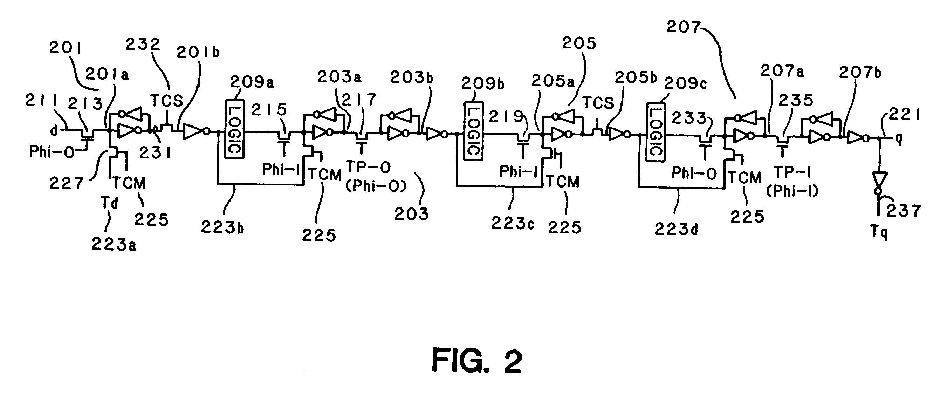

By using the present invention, the undesirable loss of data during a scan procedure can be avoided completely, even when the scan procedure accesses different types of storage devices operating on different clocks. Figure 2 illustrates such a scan procedure. Figure 2 shows two of the inventive latches, 201 and 205, of the type illustrated in figure 1, connected in series with two conventional flip-flops, 203 and 207. Each of the storage elements is separated by a logic block 209a, 209b and 209c. Additionally, there are two different clocks controlling the storage elements during a normal run, designated by Phi-0 and Phi-1 in figure 2. Phi-0 and Phi-1 are out of phase by 180 degrees in the example that is illustrated.

In a normal run, data would enter the sequence via data path 211 and be stored in latch 201 when the Phi-0 clock transmitted a logic HIGH signal to transistor 213. Because this latch would be operating in the first mode described above, this data would be available on both nodes 201a and 201b of the latch. The data would then pass through logic block 209a and be available for entry into flip-flop 203 when the Phi-1 clock transmitted a logic HIGH signal to transistor 215 in the next phase. Upon entering flip-flop 203, the data is available on node 203a of the flip-flop and prevented from entering node 203b until the next phase, as is conventional with a flip-flop. When the Phi-0 clock transmits a logic HIGH signal to transistor 217 in the next phase, the data moves and is available at node 203b and continues through logic block 209b. There the data is available to enter a second inventive latch 205 in the next phase, when the phi-1 clock transmits a logic HIGH signal to transistor 219. Upon entering latch 205 the data is made available in both sections 205a and 205b, because the latch is operating in the first mode described above.

The data will continue along this path in the manner described above, which is understandable to those skilled in the art by referring to the figure. The only difference is that inventive latch 205 is being controlled by the opposite clock that inventive latch 201 is being controlled by, similarly the control of flip-flop 207 is based on the opposite clocks of flip-flop 203. Upon passing through the sequence the data will leave through data exit line 221. Thus, figure 2 illustrates an example representative of a data or control path containing all combinations of an inventive latch and a conventional flip-flop operating on two different clocks.

In scan mode, the inventive latches are operating in the second mode of operation, as described above and illustrated in Figure 2. As a result, test data (td) enters the inventive latches via test data entry line 223a, as controlled by a test master clock 225.

During scan, a controller (not shown) generates a test phi-0 (TP-0), a test phi-1 (TP-1) a test slave clock (tcs) 232 (which is the inversion of the test master clock 225) and controls the phi-0 and phi-1 clocks used during normal operation of the circuit. The test phi-0 clock is used to control transistor 217, while the test phi-1 clock is used to control transistor 235. Transistors 215, 219 and 233 are controlled to remain off, by phi-1 and phi-0 clocks generated by the controller. In scan mode, the test data enters the sequence through line 223a and is stored in section 201a of the inventive latch 201 when the master test clock 225 transmits a logic HIGH signal to transistor 227. The inventive latch is now divided into two sections by transistor 231, because it is open in response to a logic HIGH signal from the test slave clock 232. The data will not pass onto section 201b of the inventive latch until the next phase, when the test slave clock transmits a logic HIGH signal to transistor 231.

Note also that during the scan operation the clocks controlling the remaining transistors in the sequence are now operated by new clocks; the test phi-1 and test phi-0 clocks.

Having described figure 2, the following novel scan sequence illustrates how data, originally present in the various storage devices is able to be scanned out of the storage devices and back in without loss; even when the devices are controlled by different clocks. Table 1 illustrates the location of the data in the various storage devices during a portion of the normal run sequence which is interrupted by a scan sequence and then returned to the normal run sequence. For convenience each of the storage devices is divided into two registers in the table below.

TABLE 1

| | Phi-0 | Phi-1 | TCM | TCS | TP-0 | TP-1 | 201a | 201b | 203a | 203b | 205a | 205b | 207a | 207b |
|---|---|---|---|---|---|---|---|---|---|---|---|---|---|---|
| $t_1$ | 1 | 0 | 0 | 1 | 1 | 0 | X | X | X | X | X | X | E | X |
| $t_2$ | 0 | 1 | 0 | 1 | 1 | 0 | X | X | X | X | C | C | E | E |
| $t_3$ | 1 | 0 | 0 | 1 | 1 | 0 | A | A | B | B | C | C | D | E |
| $s_1$ | 0 | 0 | 0 | 1 | 1 | 1 | A | A | B | B | C | C | D | D |
| $s_2$ | 0 | 0 | 1 | 0 | 0 | 0 | D | A | A | B | B | C | C | D |
| $s_3$ | 0 | 0 | 0 | 1 | 1 | 1 | D | D | A | A | B | B | C | C |
| $s_4$ | 0 | 0 | 1 | 0 | 0 | 0 | C | D | D | A | A | B | B | C |
| $s_5$ | 0 | 0 | 0 | 1 | 1 | 1 | C | C | D | D | A | A | B | B |
| $s_6$ | 0 | 0 | 1 | 0 | 0 | 0 | B | C | C | D | D | A | A | B |
| $s_7$ | 0 | 0 | 0 | 1 | 1 | 1 | B | B | C | C | D | D | A | A |
| $s_8$ | 0 | 0 | 1 | 0 | 0 | 0 | A | B | B | C | C | D | D | A |
| $s_9$ | 0 | 0 | 0 | 1 | 1 | 1 | A | A | B | B | C | C | D | D |
| $t_4$ | 0 | 1 | 0 | 1 | 0 | 1 | A | A | $B_1$ | B | $C_1$ | $C_1$ | D | D |

Data labeled A, B, C, D and E is located in the registers at $t$, the period just prior to the scan sequence which begins at $s$. Note that one goal is to scan this data out and then return the registers to the condition they would be in if there had been no scan. By comparing the data in the registers at $t_3$ and $s_9$, the reader will note that data A, B, C and D are in the same registers just prior to the scan and at the end of the scan. Only data E, in register 207b at $t_3$, is missing from the data stored at $s_9$; however, at $t_3$, register 207b is about to be written over, this is of no consequence since data E will be cleared in normal operation anyway.

The reader will note that, during the scan, all of the data in the registers is scanned out of the registers and made available to the tester on line 237, which tracks the data in register 207b. Thus by looking at the data that is stored in register 207b during the scan, the reader will note that data A, B, C and D are all available to the tester during the scan. The scan uses the output on line 237 to replace the data into the registers during the scan. In the example shown in table 1, data available to the tester at register 207b is used as the input to register 201a at the beginning of the next time period.

For example, at $s_3$, data register 207b and line 237 contain data C which is input into register 201a in the next period, $s_4$. However, a test procedure could include modifying some or all of the data, as it is being reentered.

Over the time period $s_1$ through $s_8$ the tester has had access to all of the data stored in the registers through test data exit line 237, however, at $s_8$ the registers do not contain the same data in the same registers as at $t_3$; a desirable result that will avoid the tester having to reconstruct the original data in another way. An additional phase of the test clocks is required to put the data into the proper registers. This additional phase, the adjustment phase, is shown in table 1 as $s_9$. It can be seen that after this adjustment phase, $s_9$, all of the relevant data in $t_3$ is properly stored in the appropriate registers. Table 1 shows that this adjustment phase is as simple as one additional phase of the test clocks. it is this adjustment phase which allows data to be correctly scanned into a scan chain which consists of flip-flops operating on two different clocks.

Note that during the normal run, the test master clock is held at logic LOW, or 0, and the test slave clock is held at logic HIGH, or 1. This prevents the data from traveling around the logic blocks along data lines 223a, 223b and 223c. During a normal run the phi-1 and phi-0 clocks alternate as described above. The test phi-1 and test phi-0 clocks are equivalent to the normal phi-1 and phi-0 clocks.

During the scan sequence, the phi-1 and phi-0 clocks are held at logic LOW, or 0, to allow the test clocks to operate the storage devices. After the test sequence, the phi-1 and phi-0 clocks continue in the same pattern that was interrupted during the scan. Thus, at $t_3$ the phi-1 clock is at logic HIGH, or 1 before it is interrupted by the scan. The phi-1 clock resumes after the scan, at $t_4$, as expected logic LOW, or 0. As can be seen in Table 1, the test clocks operate in a regular, alternating pattern during the scan operation.

For completeness, Table 1 illustrates the creation of the data from otherwise unknown values labeled "X" (which do not have to be all of the same value). For example, at $t_1$, register 205b contains such unknown data which is processed through logic 209c to create data E. Similarly, at $t_2$, unknown data in register 203b is processed through logic 209b to create data C. Data $B_1$ and $C_1$, identified in table 1, at $t_4$, are new values created during the normal run of the logic sequence.

Table 1 illustrates a scan sequence beginning when phi-0 is logic HIGH, or 0. The same table can easily be constructed for a scan sequence beginning when phi-0 is logic LOW, or 1. The same advantageous results are obtained.

From the preceding example, it should be noted that the Scannable latch and the method of testing using the latch are transparent during the normal functioning of the circuit. That is the test features do not effect the operation of the circuit when the test is not being done. Some standard test procedures require this type of transparent test procedure.

For example, the Joint Test Action Group (JTAG) was formed to resolve and standardize a method of testing complex circuit boards, including consideration of scan-based IC testing. JTAG formulated a "Standard Test Access Port and Boundary Scan Architecture," which was adopted by the IEEE as standard 1149.1. The inventive latch and method of testing described above can be operated to be compatible with the control methods described in the IEEE standard; the dynamic nature of the latch slaves only affecting the scan application when the test clock is HIGH, which is permitted in the standard. In this case, the master test clock signal is derived from the JTAG pin "TCK", and the test slave clock is in the anti-phase of this master clock.

Operating the inventive latch in the third mode of operation, it behaves as a conventional flip-flop, albeit in the implementation shown, having a dynamic slave stage. This mode of operation is particularly useful in manufacturing testing, where it is useful to not only scan the data out of the registers, but to also scan in new data. By operating the latch in the second mode, as discussed above, data can be scanned out, by then operating the latch in the third mode new data can be scanned in.

For example, in figure 2, the phi-1 and phi-0 can be driven in phase with one another, while the test phi-1 and test phi-0 and test slave clocks are driven in the opposite phase. The inventive latch will now behave as a flip-flop and all of the latches and flip-flops in figure 2 will be in phase. As a result test data can easily be entered into the registers, even by some commercially available automatic test pattern generator programs.

The inventive latch in figure 1 can be used in all three modes to provide improved test results. In a normal run, the latch is transparent and can operate in conjunction with other storage elements operated by different clocks. Using the second mode, combined with the novel adjustment phase, data can be scanned out of the registers to be observed, or modified, and returned to the registers; a particularly useful function for design verification and debugging tests. Finally manufacturing tests can be readily performed, using both the second mode to scan data in and out of the registers and the third mode of operation to operate the inventive latch as a flip-flop during the manufacturing test procedures.

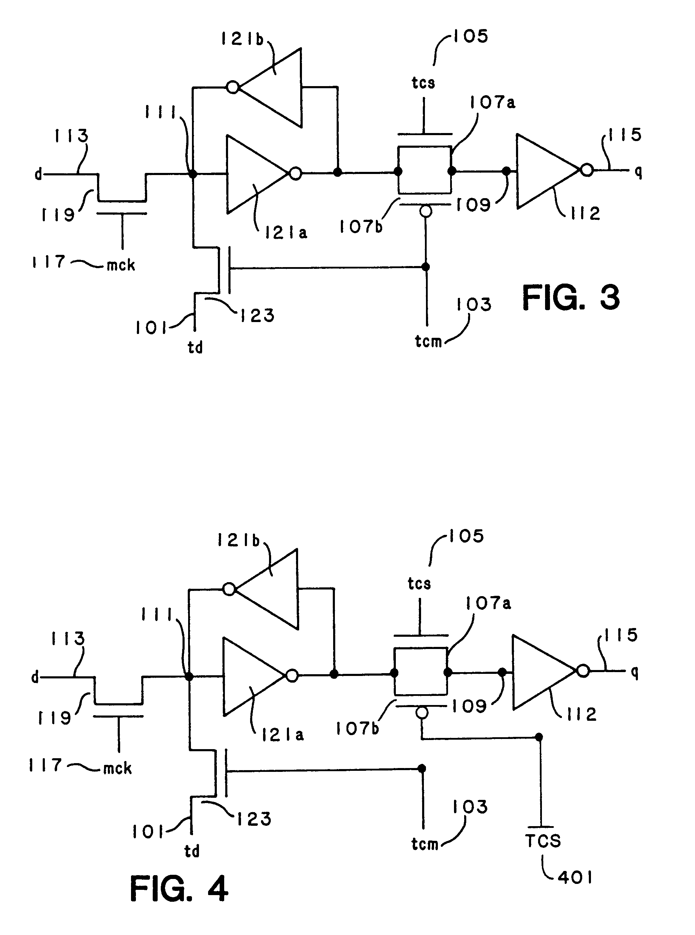

A second embodiment of the inventive latch, is illustrated in figure 3. It is similar to the inventive latch in figure 1, but includes an additional transistor 107b, which is operated by the test master clock 103. This transistor works in combination with transistor 107a. The use of two different types of transistors, in this case a p-type and an n-type transistor, creates a transmission gate improving the voltage swing in section 109.

Figure 4 illustrates another embodiment of the inventive latch. In this embodiment the latch transistor 107b is operated from a different clock, the second test slave clock signal 401. The second test clock signal is generated to be follow the inverted test slave clock 105. In operation this embodiment operates similar to the embodiment shown in figure 3. This embodiment allows the latch to be operated similarly to the third mode of the inventive latch disclosed in figure 1. By opening transistor 123, via master test clock 103, it possible to operate the latch as a flip-flop between data entry path 113 and data path 115. Controlling transistors 107a and 107b with clocks 105 and 401 respectively , allows the inventive latch to be operated as a flip-flop. The use of the p-type transistor and the n-type transistor in conjunction improves the voltage swing on node 109.

Although this invention has been described with particularity with reference to a preferred embodiment set forth in Figures 1, 2, 3 and 4 it will apparent to one skilled in the art that the present invention has utility far exceeding that disclosed in the figures. Additions, subtractions and other modifications of the preferred embodiment of the invention will be apparent to those skilled in the art and are within the scope of the following claims.

**Claims**

1. An improved latch comprising:
   a first storage region;
   at least one transistor in series with the first storage region;
   a second storage region created by at least one inverter in series with the transistor;
   the inverter having a suitable input capacitance to retain a charge, wherein said charge represents data.

2. The invention of claim 1 further comprising:
   an input line in series with the storage region;
   an output line in series with the inverter;
   a control means to control the transistor to move the data from the first storage region to the second storage region.

3. An improved Scannable latch comprising;
   a first storage region;
   at least one transistor in series with the first storage region;
   a second storage region created by at least one inverter in series with the transistor;
   the inverter having a suitable input capacitance to retain a charge, wherein said charge represents data;
   a controllable test data input line for entering data into the latch;
   a control means for controlling the test data input line and the transistor such that the Scannable latch is able to retain data in both the storage element and the capacitance region.

4. A method of scanning data into the inventive latch of claim 1, including utilizing an adjustment phase, which allows a functional scan chain to be constructed using registers that could be normally operated from different phase clocks.

FIG. 1

**FIG. 2**

FIG. 3

FIG. 4

| | European Patent Office | EUROPEAN SEARCH REPORT | | Application Number EP 95 30 1252 |

## DOCUMENTS CONSIDERED TO BE RELEVANT

| Category | Citation of document with indication, where appropriate, of relevant passages | Relevant to claim | CLASSIFICATION OF THE APPLICATION (Int.Cl.6) |
|---|---|---|---|
| A | US-A-5 172 011 (LEUTHOLD ET AL.) * column 6, line 40 - column 7, line 23; figure 6 * | 1-3 | H03K3/037 |
| A | GB-A-2 261 562 (HEWLETT-PACKARD) * page 8, line 16 - page 11, line 5; figure 4 * | 1-3 | |
| A | EP-A-0 224 004 (SONY) * column 7, line 6 - column 9, line 23; figure 4 * | 1-3 | |
| A | EP-A-0 464 746 (NEC) * column 4, line 3 - column 5, line 4; figure 1 * | 1-3 | |
| A | EP-A-0 178 012 (N.V. PHILIPS) * page 2, line 37 - page 3, line 18; figure 1 * | 1,2 | |
| A | GAAS IC SYMPOSIUM TECHNICAL DIGEST 1991, 20 October 1991, MONTEREY, CA, US pages 229 - 232 K. TANAKA ET AL. 'HIGH SPEED 8:1 MULTIPLEXER AND 1:8 DEMULTIPLEXER ICs USING GaAs DCFL CIRCUIT' * page 229; figure 1 * | 1,2 | TECHNICAL FIELDS SEARCHED (Int.Cl.6) H03K G06F |

The present search report has been drawn up for all claims

| Place of search | Date of completion of the search | Examiner |
|---|---|---|
| BERLIN | 29 June 1995 | Taylor, P |